# EUROPÄISCHE PATENTANMELDUNG

(11) **EP 1 760 858 A1**
(43) Veröffentlichungstag der Anmeldung: **07.03.2007**
(21) Anmeldenummer: 06018140.1
(22) Anmeldetag: 30.08.2006
(51) Int. Cl.: H02H 9/04

(54) **Schaltungsanordnung zur begrenzung der Eingangsspannung an einem anschluss-pin einer integrierten Schaltung**

(30) Priorität: 30.08.2005 DE 102005041073
(71) Anmelder: Patent-Treuhand-Gesellschaft für elektrische Glühlampen mbH, 81543 München (DE)
(72) Erfinder: Heckmann, Markus, 511495 Guangzhou (CN); Siegmund, Thomas. Dr., 83624 Otterfing (DE)

(57) **Zusammenfassung**

Die vorliegende Erfindung betrifft eine Schaltungsanordnung zur Begrenzung der Eingangsspannung an einem Anschluss-Pin (16) einer integrierten Schaltung (1), welche mit dem Anschluss-Pin (16) elektrisch verbunden ist, wobei die Schaltungsanordnung (5) als gestaffelte Begrenzer- und Filterschaltung ausgebildet ist.

## Beschreibung

### Technisches Gebiet

Die vorliegende Erfindung betrifft eine Schaltungsanordnung zur Begrenzung der Eingangsspannung an einem Anschtuss-Pin einer integrierten Schaltung, wobei die Schaltungsanordnung mit dem Anschluss-Pin elektrisch verbunden ist.

### Stand der Technik

Anschluss-Pins von integrierten Schaltungen dürfen im Allgemeinen nur mit Spannungen innerhalb eines spezifizierten Wertebereichs beaufschlagt werden. Es treten jedoch immer wieder Bctricbszustände auf, in denen Spannungswerte an einem Anschluss-Pin dieser integrierten Schattung auftreten, welche außerhalb dieses vorgegebenen Wertebereichs liegen. Derartige Betriebszustände, in denen diese Spannungsfenster überschritten werden, führen oft zu Fehlverhalten oder Defekten der integrierten Schaltung. Bei den üblichen integrierten Schaltungen darf ein Spitzenwert der angelegten Spannungen nicht mehr als 0,3 V über der positiven oder nicht weniger als - 0,3 V unter der negativen Versorgungsspannung liegen. Darüber hinaus ist oft auch ein minimaler oder maximaler Spannungswert mit einem Potential im Bereich der Versorgungsspannung definiert. Abhängig von der Anwendung der integrierten Schaltung sind externe Maßnahmen bekannt, um das Überschreiten dieser Spannungsgrenzwerte verhindern zu können. Insbesondere sind derartige Schutzmaßnahmen dann erforderlich, wenn extern verursachte Transienten auftreten können.

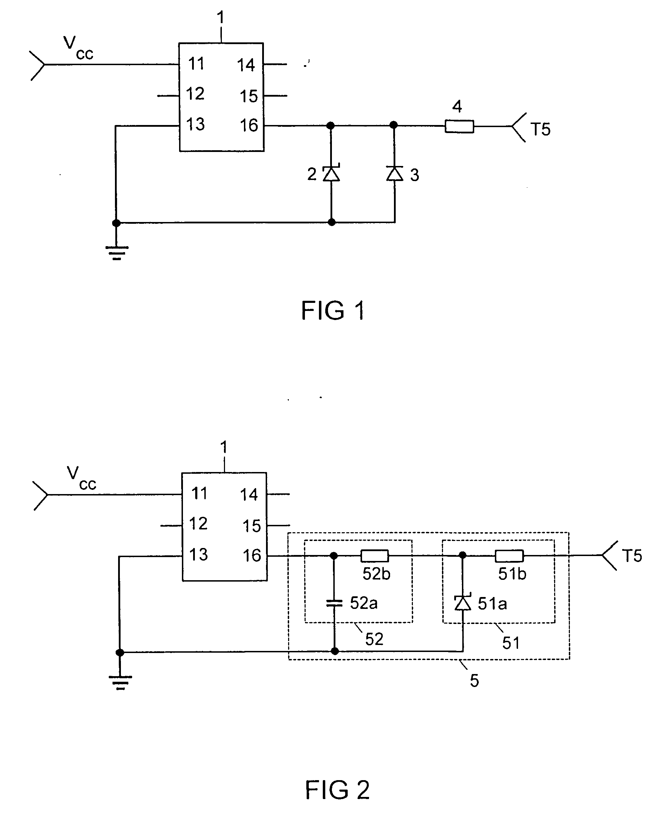

In Figur 1 ist eine bekannte Schaltungsanordnung gezeigt, welche zur Begrenzung der Eingangsspannung an einem Anschluss-Pin einer integrierten Schaltung ausgebildet ist. In Figur 1 weist eine integrierte Schaltung 1 sechs Anschluss-Pins 11 bis 16 auf, wobei ein erster Anschluss-Pin 11 zur Versorgung der integrierten Schaltung 1 mit einer Versorgungsspannung V_{CC} verbunden ist. Darüber hinaus ist die integrierte Schaltung 1 über einen weiteren Anschluss-Pin 13 mit Massepotential verbunden. Über den Anschluss-Pin 16 ist es möglich, dass Transienten Ts, welche extern verursacht sind, an die integrierte Schaltung 1 übertragen werden. Im Stand der Technik ist zur Vermeidung der Übertragung dieser Transienten Ts an eine Geräteschaltung und somit zur Vermeidung von zu hohen Eingangsspannungen an der integrierten Schaltung 1 eine Zener-Diode 2, sowie eine Schottkydiode 3 mit dem Anschluss-Pin 16 elektrisch verbunden. Darüber hinaus ist ein Widerstand 4 zwischen dem Anschluss-Pin 16 und dm Transientenbilder geschaltet. Mittels der Zener-Diode 2 wird der Anschluss-Pin 16 der integrierten Schaltung 1 gegenüber der Versorgungsspannung V_{CC} geklemmt. Um die Anforderung von -0,3 V gegenüber der Versorgung der integrierten Schaltung 1 einzuhalten, ist die Schottkydiode 3 vorgesehen. Ein wesentlicher Nachteil dieser Anordnung ist darin zu sehen, dass die hohen Leckströme dieser Schottkydiode 3 bei sehr empfindlichen integrierten Schaltungen 1, insbesondere bei erhöhten Temperaturen, die Funktion der integrierten Schaltung 1 beeinträchtigen.

### Darstellung der Erfindung

Der vorliegenden Erfindung liegt deshalb die Aufgabe zu Grunde, eine Schaltungsanordnung zu schaffen, mit welcher die Eingangsspannung an einem Anschluss-Pin einer integrierten Schattung effektiv und effizient begrenzt werden kann und darüber hinaus eine Beeinträchtigung der integrierten Schaltung durch die Schaltungsanordnung verhindert werden kann.

Diese Aufgabe wird durch eine Schaltungsanordnung, welche die Merkmale nach Patentanspruch 1 aufweisen, gelöst.

Eine erfindutigsgemäße Schaltungsanordnung zur Begrenzung der Eingangsspannung an einem Anschluss-Pin einer integrierten Schaltung ist als gestaffelte Begrenzer- und Filterschaltung ausgebildet, wobei die erfindungsgemäße Schaltungsanordnung als externe Schaltungsanordnung ausgebildet ist und mit dem Anschluss-Pin der integrierten Schaltung elektrisch verbunden ist. Indem gemäß der Erfindung die Schaltungsanordnung sowohl eine Begrenzerschaltung als auch eine Filterschaltung aufweist und diese beiden Schaltungen gestaffelt ausgebildet sind, kann einerseits ermöglicht werden, dass die Begrenzung der Eingangsspannung an diesem Anschluss-Pin der integrierten Schaltung effizient und effektiv begrenzt werden kann und somit eine Beschädigung oder ein Fehlverhalten der integrierten Schaltung verhindert werden kann.

In vorteilhafter Weise ist die erfindungsgemäße Schaltungsanordnung aus zwei Teilschaltungen aufgebaut, wobei die erste Teilschaltung als Spannungsbegrenzer-Schaltung ausgebildet ist. Die zweite Teilschaltung ist als Filterschaltung ausgebildet. Eine gestaffelte Begrenzer- und Filterschaltung, welche darüber hinaus durch zwei separate Teilschaltungen ausgebildet ist, erlaubt einen sehr wirksamen Schutz gegen Transienten.

Die erste Teilschaltung umfasst in bevorzugter Weise ein strombegrenzendes Bauelement, insbesondere einen Widerstand oder eine Induktivität. Darüber hinaus weist diese erste Teilschaltung auch eine Diode auf, welche insbesondere als Zener-Diode ausgebildet ist. Dadurch kann bereits eine sehr wirksame Begrenzung erfolgen, wobei das Signal an dem Anschluss-Pin, mit dem die erfindungsgemäße Schaltungsanordnung verbunden ist, auf etwa 0,7 V gegen eine Versorgungsspannung geklemmt wird.

Die zweite Teilschaltung ist in bevorzugter Weise als Tiefpassfilterschaltung ausgebildet. Dadurch können die Transienten nochmals reduziert bzw. begrenzt werden und auf einen unbedenklichen Wert vermindert werden.

Es kann vorgesehen sein, die zweite Teilschaltung zwischen den Anschluss-Pin der integrierten Schaltung und die erste Teilschaltung zu schalten. Die zweite Teilschaltung kann mit einem ersten Anschluss mit der integrierten Schaltung, mit einem zweiten Anschluss mit einem Ausgang der ersten Teilschaltung und mit einem dritten Anschluss mit Massepotential verbunden sein. Es kann auch vorgesehen sein, dass die erste Teilschaltung mit einem ersten Anschluss mit der zweiten Teilschaltung, mit einem zweiten Anschluss mit Massepotential und mit einem dritten Anschluss mit einem Transientenbilder elektrisch verbunden ist. Dadurch kann eine erfindungsgemäße Schaltungsanordnung ausgebildet werden, mit der das Signal des Transientenbilders zunächst an die erste Teilschaltung übertragen wird, und eine erste Begrenzung der Transienten durchgeführt wird. Das Ausgangssignal dieser ersten Teilschaltung wird dann an die zweite Teilschaltung übertragen, mittels derer eine Filterung dieses Ausgangssignals der ersten Teilschaltung durchgeführt wird und dadurch eine nochmalige Reduzierung der Transienten dahingehend erreicht werden kann, dass das Beschädigen oder Verursachen von Fehlverhalten der integrierten Schaltung verhindert werden kann. Das Ausgangssignal der zweiten Teilschaltung, welches an dem Ansehluss-Pin der integrierten Schaltung anliegt, ist dabei derart, dass die Transienten auf einen Wert reduziert sind, welche die Funktionsfähigkeit der integrierten Schaltung nicht mehr beeinträchtigen.

Es kann auch vorgesehen sein, dass das Signal eines Transientenbilders zunächst an die zweite Teilschaltung übertragen wird und somit als erster Schritt eine Filterung dieses Transientensignals durchgeführt wird und erst nachfolgend eine weitere Begrenzung durch die erste Teilschaltung durchgeführt wird, in dem die erste Teilschaltung der zweiten Teilschaltung nachgeschaltet ist. In einer derartigen Ausführung wird dann das Ausgangssignal der ersten Teilschaltung an den Anschluss-Pin der integrierten Schaltung übertragen. Auch durch diese Ausgestaltung kann eine effektive und effiziente Reduzierung der Transienten erreicht werden und somit die Beeinträchtigung der Funktionsweise der integrierten Schaltung durch extern verursachte Transienten verhindert werden.

In vorteilhafter Weise ist ein elektronisches Vorschaltgerät zum Einstellen und Betreiben einer elektrischen Lampe, insbesondere einer Leuchtstofflampe derart ausgebildet, dass es eine erfindungsgemäße Schaltungsanordnung oder eine vorteilhafte Ausgestaltung davon aufweist. Das elektronische Vorschaltgerät weist darüber hinaus auch eine integrierte Schaltung mit einem Anschluss-Pin auf, wobei mit diesem Anschluss-Pin die erfindungsgemäße Schaltungsanordnung elektrisch verbunden ist.

### Kurze Beschreibung der Zeichnungen

Ein Ausführungsbeispiel der Erfindung wird nachfolgend anhand einer schcmatischcn Zeichnung näher erläutert. Es zeigen:
- Figur 1: eine aus dem Stand der Technik bekannte Schaltungsanordnung zur Begrenzung der Eingangsspannung an einem Anschtuss-Pin einer integrierten Schaltung; und
- Figur 2: eine erfindungsgemäße Schaltungsanordnung.

### Bevorzugte Ausführung der Erfindung

In Figur 2 ist in schematischer Darstellung eine Schaltung gezeigt, welche im Ausführungsbeispiel in einem elektronischen Vorschaltgerät angeordnet ist, wobei das elektronische Vorschaltgerät zum Einstellen oder Betreiben einer elektrischen Lampe ausgebildet ist. Eine integrierte Schaltung 1 wird über einen ersten Anschluss-Pin 11 mit einer Versorgungsspannung V_{CC} versorgt. Die integrierte Schaltung 1 weist im Ausführungsbeispiel sechs Anschluss-Pins 11 bis 16 auf, wobei an dem Anschtuss-Pin 13 eine elektrische Verbindung der integrierten Schaltung 1 mit Massepotential vorgesehen ist. Im Ausführungsbeispiel gemäß Figur 2 ist die integrierte Schaltung 1 mit dem Anschluss-Pin 16 mit einem Transientenbilder, welcher beispielsweise die elektrische Lampe sein kann, elektrisch verbunden. Der Transientenbilder kann durch Schaltvorgänge Transienten erzeugen, welche an den Anschluss-Pin 16 übertragen werden können. Um eine derartige Übertragung dieser Transienten an den Anschluss-Pin 16 und somit an die integrierte Schaltung 1 verhindern zu können, ist zwischen dem Transientenbilder und dem Anschluss-Pin 16 eine erfindungsgemäße Schaltungsanordnung 5 zur Begrenzung der Eingangsspannung an dem Anschluss-Pin 16 ausgebildet.

Die Ausgestaltung in Figur 2 ist lediglich beispielhaft. Es kann auch vorgesehen sein, dass die Schaltungsanordnung 5 alternativ oder zusätzlich an den Anschlüssen 12, 14 und/oder 15 der integrierten Schaltung 1 ausgebildet ist. Bevorzugt ist jeweils eine erfindungsgemäße Schaltungsanordnung 5 mit denjenigen Anschluss-Pins der integrierten Schaltung 1 verbunden, welche mit Komponenten verbunden sind, bei deren Betrieb Transienten auftreten können.

Im Ausführungsbeispiel ist die erfindungsgemäße Schaltungsanordnung 5 als gestaffelte Begrenzer- und Filterschaltung ausgebildet und weist eine erste Teilschaltung 51 auf, welche als Spannungsbegrenzer-Schaltung ausgebildet ist. Die Schaltungsanordnung 5 weist eine zweite Teilschaltung 52 auf, welche als Filterschaltung ausgebildet ist und der ersten Teilschaltung 51 nachgeschaltet ist.

Wie im Ausführungsbeispiel zu erkennen ist, ist die erste Teilschaltung 51 mit einem Eingang mit dem Transientenbilder (nicht dargestellt) elektrisch verbunden, so dass das Signal dieses Transientenbilders und somit auch die Transienten Ts zunächst an die erste Teilschaltung 51 übertragen werden. Die erste Teilschaltung 51 umfasst im Ausführungsbeispiel eine Zener-Diode 51a und einen Widerstand 51b. Wie aus der Darstellung in Figur 2 zu entnehmen ist, ist die erste Teilschaltung 51, insbesondere die Zener-Diode 51a, mit Massepotential verbunden. Darüber hinaus weist die erste Teilschaltung 51 einen Ausgang auf, welcher mit einem Eingang der zweiten Teilschaltung 52 verbunden ist. Die zweite Teilschaltung 52 ist im Ausführungsbeispiel als Tiefpassfilter ausgebildet und weist einen Kondensator 52a und einen Widerstand 52b auf. Auch die zweite Teilschaltung ist mit Massepotential verbunden. Das Ausgangssignal der zweiten Teilschaltung und somit das Ausgangssignal der erfindungsgemäßen Schaltungsanordnung 5 liegt an dem Anschluss-Pin 16 an. Gemäß der Erfindung wird das an der ersten Teilschaltung 51 anliegende Signal und damit auch die Transienten Ts auf etwa 0,7 V gegen die Versorgungsspannung V_{CC} geklemmt, wobei die zweite Begrenzung durch die entsprechende Wahl der Zener-Diode 51 a dimensionierbar bzw. vorgebbar ist. Die Transienten Ts sind somit am Ausgang der ersten Teilschaltung 51 bereits auf etwa 0,7 V geklemmt und können durch die nachgeschaltete zweite Teilschaltung 51 weiter auf einen unbedenklichen Wert reduziert werden. Eine Reduzierung kann dabei auf einen Wert von etwa 0,3 V oder darunter erreicht werden.

## Patentansprüche

1. Schaltungsanordnung zur Begrenzung der Eingangsspannung an einem Anschluss-Pin (16) einer integrierten Schaltung (1), welche mit dem Anschluss-Pin (16) elektrisch verbunden ist,
**dadurch gekennzeichnet, dass**
die Schaltungsanordnung (5) als gestaffelte Begrenzer- und Filterschaltung ausgebildet ist.

2. Schaltungsanordnung nach Anspruch 1,
**gekennzeichnet durch**
eine erste Teilschaltung (51), welche als Spannungsbegrenzer-Schaltung ausgebildet ist und eine zweite Teilschaltung (52), welche als Filterschaltung ausgebildet ist.

3. Schaltungsanordnung nach Anspruch 2,
**dadurch gekennzeichnet, dass**
die erste Teilschaltung (51) ein strombegrenzendes Bauelement, insbesondere einen Widerstand (51b) oder eine Induktivität, und eine Diode, insbesondere eine Zener-Diode (51a), aufweist.

4. Schaltungsanordnung nach Anspruch 2 oder 3,
**dadurch gekennzeichnet, dass**
die zweite Teilschaltung (52) als Tiefpassfilter ausgebildet ist.

5. Schaltungsanordnung nach einem der vorhergehenden Ansprüche 2 bis 4,
**dadurch gekennzeichnet, dass**
die zweite Teilschaltung (52) zwischen den Anschluss-Pin (16) der integrierten Schaltung (1) und die erste Teilschaltung (51) geschaltet ist.

6. Schaltungsanordnung nach Anspruch 5,
**dadurch gekennzeichnet, dass**
die zweite Teilschaltung (52) mit einem ersten Anschluss mit dem Anschluss-Pin (16) der integrierten Schaltung (1), mit einem zweiten Anschluss mit einem Ausgang der ersten Teilschaltung (51) und mit einem dritten Anschluss mit Massepotenzial verbunden ist.

7. Schaltungsanordnung nach Anspruch 5 oder 6,
**dadurch gekennzeichnet, dass**
die erste Teilschaltung (51) mit einem ersten Anschluss mit der zweiten Teilschaltung (52), mit einem zweiten Anschluss mit Massepotenzial und mit einem dritten Anschluss mit einem Transientenbildner elektrisch verbunden ist.

8. Schaltungsanordnung nach einem der Ansprüche 2 bis 4,
**dadurch gekennzeichnet, dass**
die erste Teilschaltung (51) zwischen den Anschluss-Pin (16) der integrierten Schaltung (1) und die zweite Teilschaltung (52) geschaltet ist.

9. Elektronisches Vorschaltgerät zum Einstellen und Betreiben einer elektrischen Lampe, insbesondere einer Leuchtstofflampe, welches eine Schaltungsanordnung nach einem der Ansprüche 1 bis 8 aufweist.
